# FASCICULE DE BREVET EUROPEEN

(11) **EP 2 024 104 B1**
(45) Date de publication et mention de la délivrance du brevet: **07.03.2012**
(21) Numéro de dépôt: 07765981.1
(22) Date de dépôt: 07.06.2007
(51) Int. Cl.: B05D 7/24, B05D 7/22, C23C 16/04

(54) **MACHINE DE TRAITEMENT DE RÉCIPIENTS PAR PLASMA, COMPRENANT UN CIRCUIT DE VIDE EMBARQUÉ**
MASCHINE ZUR PLASMABEHANDLUNG VON BEHÄLTERN MIT EINEM INTEGRIERTEN VAKUUMKREISLAUF
MACHINE FOR PLASMA TREATMENT OF CONTAINERS COMPRISING AN INTEGRATED VACUUM CIRCUIT

(30) Priorité: 08.06.2006 FR 0605089
(43) Date de publication de la demande: 18.02.2009
(73) Titulaire: Sidel Participations, 76930 Octeville Sur Mer (FR)
(72) Inventeur: RIUS, Jean-Michel, F-76930 Octeville sur Mer (FR)
(74) Mandataire: Demulsant, Xavier
(86) Numéro de dépôt international: PCT/FR2007/000938
(87) Numéro de publication internationale: WO 2007/141426

(56) Documents cités:
- EP-A- 1 652 961
- WO-A-94/00247
- FR-A1- 2 847 912

## Description

L'invention a trait à la fabrication des récipients, au cours de laquelle on revêt leur paroi interne d'une couche comprenant un matériau à effet barrière.

Il est connu d'effectuer le dépôt du matériau à effet barrière par plasma activé en phase vapeur (PECVD : Plasma Enhanced Chemical Vapor Déposition). On utilise classiquement une machine équipée d'une pluralité d'unités de traitement comprenant chacune un générateur d'ondes électromagnétiques, une cavité reliée au générateur et réalisée dans un matériau conducteur (généralement métallique), ainsi qu'une enceinte disposée dans la cavité et réalisée dans un matériau (généralement du quartz) transparent aux ondes électromagnétiques en provenance du générateur.

Après introduction du récipient (généralement réalisé dans un matériau polymère thermoplastique tel que PET) dans l'enceinte, un vide poussé (de quelques µbars - rappelons que 1 µbar = 10⁻⁶ bar), nécessaire à l'établissement du plasma, est fait à l'intérieur du récipient, cependant qu'un vide moyen (de l'ordre de 30 mbar à 100 mbar) est fait dans l'enceinte à l'extérieur du récipient afin d'éviter que celui-ci ne se contracte sous l'effet de la différence de pression entre l'intérieur et l'extérieur du récipient.

Un gaz précurseur (tel que de l'acétylène) est ensuite introduit dans le récipient, ce précurseur étant activé par bombardement électromagnétique (il s'agit généralement de micro-ondes UHF à 2,45 GHz, de faible puissance) pour le faire passer à l'état de plasma froid et ainsi générer des espèces parmi lesquelles du carbone hydrogéné (comprenant CH, CH2, CH3) qui se dépose en couche mince (dont l'épaisseur est classiquement comprise entre 50 et 200 nm selon les cas - rappelons que 1nm = 10⁻⁹ m) sur la paroi interne du récipient.

Pour plus de détails, on pourra se reporter au brevet européen N° EP 1 068 032 (Sidel).

La mise en oeuvre industrielle de cette technologie a suscité de nombreuses difficultés, dont l'une a trait au vide auquel doit être soumis l'intérieur du récipient pour en évacuer l'air (essentiellement composé d'oxygène et d'azote) dont les molécules d'oxygène (O₂) seraient, d'une part, susceptibles de réagir avec les espèces générées par le plasma et, d'autre part, risqueraient également d'être absorbées par la couche barrière, atténuant ainsi ses propriétés barrière (ce que l'on souhaite éviter).

Pour la mise au vide de l'enceinte, la machine comprend généralement un circuit de vide qui raccorde l'enceinte à une source de dépression disposée à l'extérieur de la machine, le circuit de vide comprenant alors un raccord tournant étanche.

La même source de dépression peut servir à la mise au vide de l'extérieur et de l'intérieur du récipient : le circuit de vide comprend alors une première terminaison, qui débouche à l'extérieur du récipient lorsque celui-ci se trouve dans l'enceinte, et une seconde terminaison débouchant à l'intérieur du récipient, avec interposition entre ces deux terminaisons d'une vanne commandée, agencée pour obturer la première terminaison lorsque le vide à l'extérieur du récipient a atteint une première valeur prédéterminée (généralement entre 30 mbar à 100 mbar, comme nous l'avons vu), la mise au vide de l'intérieur du récipient, via la seconde terminaison, se poursuivant jusqu'à obtention d'une seconde valeur prédéterminée (de quelques µbars). Un tel agencement est décrit dans le brevet européen EP 1 228 522 (Sidel).

Dans la mesure où de la qualité du vide dépend, dans une certaine mesure, la qualité du revêtement, les constructeurs ont compris qu'il était nécessaire de munir leurs machine de moyens de contrôle de la pression régnant dans l'enceinte, et surtout de la pression régnant à l'intérieur du récipient où, comme nous l'avons vu, le vide est particulièrement poussé. C'est le cas par exemple de la machine décrite dans la demande de brevet européen N°1 439 839 (Mitsubishi).

Plusieurs technologies de capteurs conviennent pour ce type d'application. Citons à titre d'exemple les jauges Pirani, les jauges à cathode froide ou chaude, ou encore les jauges capacitives qui, à l'heure actuelle, offrent les meilleures performances : leur domaine de fonctionnement, compris entre 10⁻⁹ à 10⁻⁷ bar d'une part, et 10⁻² à 1 bar d'autre part, couvre en effet la gamme de vide réalisé dans les enceintes de traitement plasma.

Dans ce type de capteur, une membrane se déforme élastiquement entre deux électrodes qui constituent avec celle-ci un condensateur dont la capacité varie en fonction de la distance entre les électrodes et la membrane.

Ce capteur étant relié à l'intérieur du récipient, on ne peut éviter que la membrane soit polluée par un dépôt d'espèces générées par le plasma lors du traitement du récipient. Au fil des traitements répétés, cette pollution fausse progressivement les mesures de pression, de sorte qu'on finit par ne plus savoir à quelle cause attribuer un écart constaté entre la pression mesuré et la pression théorique souhaitée : à un défaut d'étanchéité du circuit de vide par exemple, ou bien à une dérive provenant du capteur lui-même.

A ces problèmes, les remèdes classiques consistent, soit à remplacer fréquemment les capteurs, soit à les ré-étalonner régulièrement. Rappelons que l'étalonnage d'un capteur de pression consiste à effectuer avec celui-ci une mesure d'une pression connue à l'avance de manière précise, de sorte à régler la valeur du « zéro » associé au capteur et évaluer la réponse dynamique du capteur, c'est-à-dire l'évolution, en fonction du temps, du signal électrique émis par le capteur lors d'une variation brusque et prédéterminée de la pression. Ces opérations, qui nécessitent toutes deux de stopper la machine afin de retirer les capteurs pour les remplacer ou pour les réétalonner au moyen d'un montage spécifique, nuisent considérablement à la productivité de la ligne de fabrication.

Le document WO 94/00247 décrit un appareil selon le préambule de la revendication 1.

L'invention vise notamment à remédier à ces inconvénients, en proposant une machine de traitement de récipients qui permette une mesure durablement fiable du vide (c'est-à-dire de la faible pression) régnant dans l'enceinte, au sein des récipients traités.

A cet effet, l'invention propose une machine de traitement de récipients par plasma, cette machine comprenant :
- une enceinte propre à recevoir un récipient à traiter, cette enceinte étant raccordée à un circuit primaire de vide,
- un capteur de pression raccordé à l'enceinte,
- des premiers moyens de mise en communication commandée du capteur de pression avec l'enceinte (par exemple sous la forme d'une électrovanne),
- un circuit secondaire de vide, indépendant du circuit primaire et raccordé au capteur de pression, et
- des seconds moyens de mise en communication du capteur de pression avec le circuit secondaire de vide (par exemple sous la forme d'une électrovanne).

Le circuit secondaire de vide comprend de préférence une source secondaire de vide embarquée, distincte d'une source primaire de vide du circuit primaire.

Suivant un premier mode de réalisation, le capteur de pression est un capteur à chambre unique, raccordée à la fois à l'enceinte et au circuit secondaire de vide.

L'invention propose également un procédé de réétalonnage de ce capteur, suivant lequel on ferme la communication entre le capteur et l'enceinte, on met le capteur en communication avec le circuit secondaire de vide, on mesure la valeur de la pression régnant dans le circuit secondaire de vide, et on affecte cette valeur à une valeur de pression de référence du capteur.

Suivant un second mode de réalisation, le capteur de pression est un capteur différentiel, dont une première chambre est raccordée à l'enceinte et une seconde chambre au circuit secondaire de vide. Sont de préférence prévus des troisièmes moyens de mise en communication des deux chambres du capteur, qui se présentent par exemple sous la forme d'une électrovanne interposée entre les deux chambres.

L'invention propose également un procédé de réétalonnage de ce capteur différentiel, suivant lequel on ferme la communication entre le capteur et l'enceinte, on met le capteur en communication avec le circuit secondaire de vide, on met les deux chambres du capteur en communication, on mesure la valeur de la pression régnant dans le circuit secondaire de vide au moyen de la seconde chambre, et on affecte cette valeur à une valeur de pression de référence de la seconde chambre. Suivant un mode de réalisation, on évalue également la réponse dynamique du capteur.

D'autres objets et avantages de l'invention apparaîtront à la lumière de la description faite ci-après en référence aux dessins annexés dans lesquels :
- la figure 1 est une vue schématique partielle montrant une machine selon l'invention, comprenant une pluralité d'unités de traitement montées sur un même carrousel tournant ;
- la figure 2 est une vue d'élévation en coupe montrant une unité de traitement équipant la machine de la figure 1, suivant un premier mode de réalisation ;
- la figure 3 est une vue similaire à la figure 2, suivant un deuxième mode de réalisation.

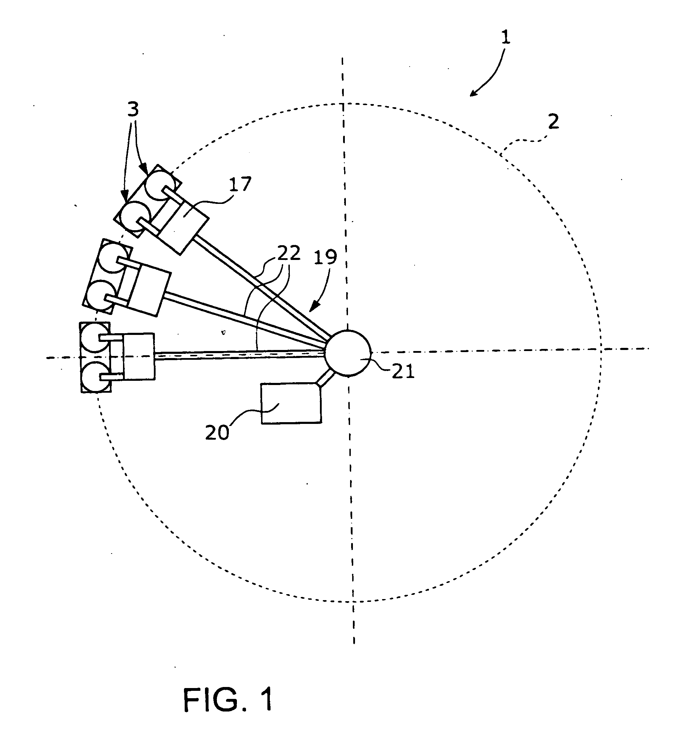

Sur la figure 1 est représentée une machine 1 comprenant un carrousel 2 sur lequel sont montées une pluralité d'unités 3 de traitement pour le dépôt par plasma d'une couche barrière sur la paroi interne de récipients 4 préalablement mis en forme par soufflage ou étirage soufflage à partir d'une ébauche en matière thermoplastique tel que PET.

Chaque unité 3 de traitement comprend un générateur 5 de micro-ondes électromagnétiques de faible puissance à une fréquence de 2,45 GHz, relié par un guide d'ondes 6 à une cavité 7 réalisée dans un matériau conducteur, par exemple en acier ou (de préférence) en aluminium ou dans un alliage d'aluminium. Dans la cavité 7 est disposée une enceinte 8 réalisée dans un matériau propre à transmettre les micro-ondes électromagnétiques, tel que du quartz.

La cavité 7 et l'enceinte 8 sont fermées par un couvercle 9 amovible permettant la mise en place étanche du récipient 4 dans l'enceinte 8. Le couvercle 9 est traversé par un injecteur 10 pour l'introduction dans le récipient 4 d'un gaz précurseur, tel que de l'acétylène. Sur le couvercle 9 est monté un support 11 auquel le récipient 4 est accroché.

La machine 1 comprend un circuit 12 primaire de vide, raccordé à chaque enceinte 8, et qui comprend une source 13 primaire commune de dépression (extérieure à la machine 1) servant à la fois à établir un vide poussé (de quelques µbars) dans le récipient 4 avant l'introduction du gaz précurseur, et à pomper les espèces résiduelles en fin de réaction, via une chambre 14 de post-décharge formée dans le couvercle 9 à l'aplomb de l'enceinte 8 et en communication permanente, lors du traitement, avec l'intérieur du récipient 4.

Il est à noter que la source 13 primaire de dépression peut être aussi mise à profit pour établir un vide moyen (de quelques millibars) dans l'enceinte 8 à l'extérieur du récipient 4, par exemple au moyen d'un système de vanne tel que décrit dans le brevet européen précité EP 1 228 522 (Sidel).

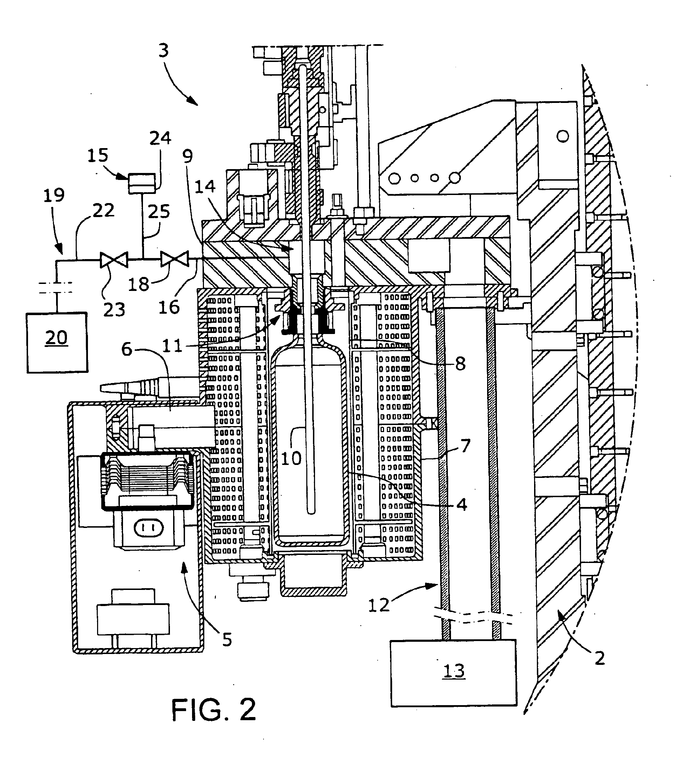

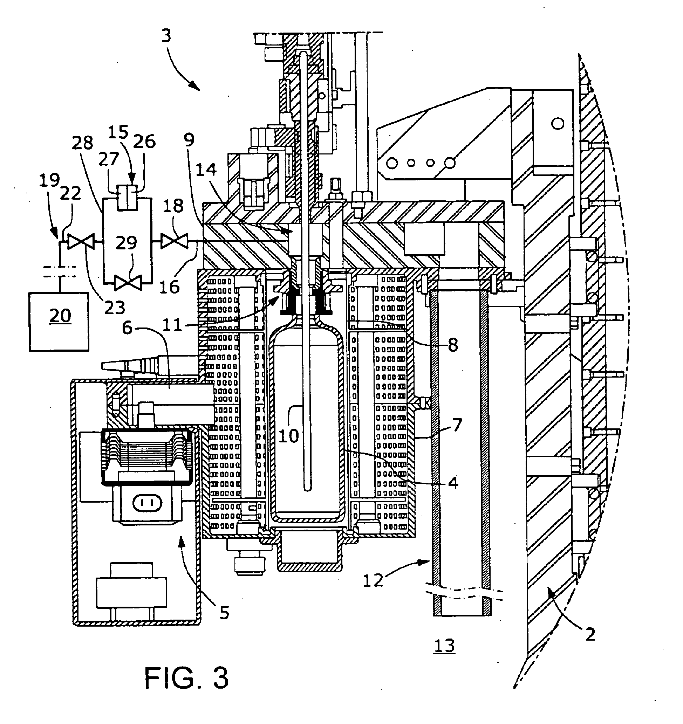

Chaque unité 3 de traitement comprend en outre, comme cela est illustré sur les figures 2 et 3, un capteur 15 de pression raccordé à l'enceinte 8 par l'intermédiaire d'une canalisation 16 débouchant dans la chambre 14 de post-décharge, où la pression est sensiblement la même qu'à l'intérieur du récipient 4. Suivant un mode de réalisation, ce capteur 15 est une jauge capacitive, ayant de préférence un domaine de mesure compris entre 10⁻⁹ bar et 10⁻² bar.

Comme représenté sur la figure 1 , où les unités 3 de traitement sont groupées par paires, ce capteur 15 est monté dans un boîtier 17 commun aux deux unités 3 de traitement d'une même paire.

Une première électrovanne 18 est interposée, sur la canalisation 16, entre le capteur 15 et la chambre 14 de post-décharge, pour permettre une mise en communication commandée du capteur 15 avec l'enceinte 8 (plus précisément avec l'intérieur du récipient 4). Pour éviter une sollicitation mécanique trop importante du capteur 15 et le maintien de celui-ci dans son domaine de mesure, l'électrovanne 18 est de préférence fermée lorsqu'en fin de traitement le couvercle 9 est séparé de l'enceinte 8 (l'enceinte 8 et la chambre 14 de post-décharge étant alors conjointement mises à l'air libre).

Par ailleurs, comme cela est représenté schématiquement sur les figures, la machine 1 comprend, de manière embarquée, un circuit 19 secondaire de vide, indépendant du circuit 12 primaire, raccordé à chaque capteur 15, et qui comprend une source 20 secondaire de dépression, distincte de la source 13 primaire. En pratique, le circuit 19 secondaire, avec sa source 20 secondaire de dépression, est monté sur le carrousel 2 et accompagne ainsi l'ensemble des unités 3 de traitement dans leur rotation. L'étanchéité du circuit 19 secondaire de vide peut, de ce fait, être facilement réalisée, ce qui garantit que le vide régnant dans le circuit 19 secondaire est constant quelle que soit la position angulaire du carrousel 2.

Suivant un mode de réalisation illustré sur la figure 1, la source 20 secondaire de dépression, par exemple une pompe turbomoléculaire produisant un vide compris entre 10⁻¹⁰ et 10⁻⁶ bar, notamment de 10⁻⁸ bar environ, est raccordée à une nourrice 21 centrale de vide montée au centre du carrousel 3, cette nourrice 21 étant elle-même raccordée à chaque capteur 15 par l'intermédiaire d'une pluralité de canalisations 22 radiales.

Comme cela est visible sur les figures 2 et 3, une deuxième électrovanne 23 est interposée, sur la canalisation 22, entre le capteur 15 et la nourrice 21 de vide, pour permettre une mise en communication commandée du capteur 15 avec la nourrice 21 et, de fait, avec la source 20 secondaire de dépression.

Deux modes de réalisation sont proposés, suivant le choix du capteur.

Suivant un premier mode de réalisation, représenté sur la figure 2, le capteur 15 est un capteur standard, à chambre 24 unique, raccordée, par l'intermédiaire d'une canalisation 25 de liaison, au circuit 19 secondaire et à l'enceinte 8, lesquels sont isolés l'un de l'autre par les électrovannes 18, 23, qui dans cette configuration ne sont jamais ouvertes simultanément.

Au cours du traitement, la première électrovanne 18 est ouverte, tandis que la deuxième électrovanne 23 est fermée. De la sorte, le capteur 15 est en communication avec l'enceinte 8 et effectue une mesure du vide (c'est-à-dire de la faible pression) qui y règne. La première électrovanne 18 est de préférence fermée à l'ouverture du couvercle 9, pendant l'évacuation du récipient 4 traité et jusqu'à la fermeture du couvercle 9 sur le récipient suivant, de sorte à éviter une mise en communication du capteur 15 avec l'air libre.

Rappelons que le vide régnant dans le récipient 4 est censé avoir une valeur prédéterminée, la mesure effectuée par le capteur 15 n'étant qu'une mesure de vérification que la valeur réelle correspond à la valeur théorique. La comparaison entre valeur réelle (mesurée) et la valeur théorique est effectuée au sein d'une unité de contrôle (non représentée), extérieure à la machine 1 et à laquelle le capteur 15 est connecté électriquement.

Comme nous l'avons évoqué en introduction, un écart sensible entre les deux valeurs de pression peut avoir deux causes : soit un vide défectueux dans le récipient 4, dû par exemple à une fuite au niveau de l'unité 3 de traitement, soit un dysfonctionnement du capteur 15, dont la pollution due au dépôt d'espèces issues du plasma affecte les performances par une dérive progressive, c'est-à-dire un écart croissant entre la pression mesurée et la pression réelle. S'il est possible de corriger de manière informatique cette dérive en programmant de manière appropriée l'unité de contrôle, une telle correction peut avoir pour effet de masquer un défaut de vide dans l'enceinte 8, attribué à tort à une dérive du capteur 15.

La présence du circuit 19 secondaire de vide, embarqué, qui fournit grâce à son étanchéité accrue (du fait notamment de l'absence de raccord tournant), un vide de référence dont la valeur, constante, est connue, permet de réétalonner régulièrement le capteur 15 en recalant son « zéro » sur le vide de référence.

Pour réétalonner le capteur 15, on ferme la première électrovanne 18, par exemple entre deux traitements de récipients successifs, et on ouvre la deuxième électrovanne 23 pour mettre en communication le capteur 15 avec le circuit 19 secondaire de vide (c'est-à-dire avec la source 20 secondaire de dépression). La valeur de pression mesurée, qui est égale au vide de référence produit par la source 20 secondaire de dépression (très inférieur au vide produit par la source 13 primaire), est affectée au sein de l'unité de contrôle au « zéro » du capteur 15, ce zéro servant de référence aux mesures effectuées ensuite par le capteur 15 dans l'enceinte 8.

La réitération d'un écart entre la valeur du vide mesuré dans le récipient 4 par le capteur 15 et sa valeur théorique témoigne alors d'un défaut inhérent à la machine 1 (tel qu'un défaut d'étanchéité au niveau de l'enceinte 8), qui nécessite une intervention pour identifier le problème et y remédier.

Suivant un second mode de réalisation, illustré sur la figure 3, le capteur 15 est un capteur différentiel, à deux chambres, dont une première chambre 26 est raccordée à l'enceinte 8, et la seconde 27 au circuit 19 secondaire, avec interposition de la première électrovanne 18 et de la deuxième électrovanne 23, respectivement.

Comme cela est illustré sur la figure 3, les deux chambres 26, 27 du capteur 15 sont en outre raccordées entre elles par une canalisation 28 de bouclage avec interposition d'une troisième électrovanne 29 pour la mise en communication commandée des chambres 26, 27.

En cours de traitement, la première électrovanne 18 et la deuxième électrovanne 23 sont toutes deux ouvertes. La seconde chambre 27 est donc soumise au vide de référence, lequel fournit donc en permanence le « zéro » du capteur 15, tandis que la première 26 est soumise au vide régnant dans le récipient 4, dont la mesure est d'abord comparée au zéro ainsi défini pour obtenir une valeur relative fiable, cette valeur relative étant ensuite comparée par l'unité de contrôle avec la valeur théorique du vide censé régner dans le récipient 4.

De même que dans le premier mode de réalisation, un écart sensible entre la valeur relative mesurée et la valeur théorique peut être dû soit à un vide défectueux dans l'unité 3 de traitement, soit à un dysfonctionnement du capteur 15, dû à la pollution présente dans la première chambre 26.

Le réétalonnage du capteur 15 différentiel consiste à équilibrer les pressions régnant dans les deux chambres 26, 27 en les mettant en communication. Ce rééquilibrage est effectué à la pression de référence en fermant la première électrovanne 18 et en ouvrant la deuxième électrovanne 23 et la troisième électrovanne 29.

On recale ainsi le « zéro » de la première chambre sur le « zéro » du capteur 15, fourni par la valeur du vide de référence mesurée dans la deuxième chambre 27.

De même que précédemment, le capteur 15 ayant été réétalonné, la réitération d'un écart entre la valeur du vide mesuré dans le récipient 4 et sa valeur théorique démontre que le défaut ne provient pas du capteur 15 et qu'il est nécessaire d'intervenir sur la machine 1.

Quel que soit le mode de réalisation retenu, les avantages procurés par la présence du circuit 19 secondaire de vide, embarqué sur la machine 1 et indépendant du circuit 12 primaire, sont évidents : la fourniture d'un vide de référence permet de réétalonner les capteurs de pression de la machine 1 sans les démonter, et sans arrêter celle-ci.

De même, quel que soit le mode de réalisation retenu, il est préférable, à l'occasion du réétalonnage du capteur 15, d'évaluer la réponse dynamique de celui-ci, c'est-à-dire de mesurer le temps qu'il met, dès lors qu'il est soumis à la pression de référence, pour se stabiliser sur la valeur mesurée. On vérifie ainsi si cette réponse dynamique est suffisamment rapide pour garantir la fiabilité des mesures de pression effectuées par le capteur 15 au sein de l'unité 3 de traitement.

## Revendications

1. Machine (1) de traitement de récipients (4) par plasma, cette machine (1) comprenant :
- une enceinte (8) propre à recevoir un récipient (4) à traiter, cette enceinte (8) étant raccordée à un circuit (12) primaire de vide,
- un capteur (15) de pression raccordé à l'enceinte (8),
- un circuit (19) secondaire de vide, indépendant du circuit (12) primaire et raccordé au capteur (15) de pression, et
- des seconds moyens (23) de mise en communication du capteur (15) de pression avec le circuit (19) secondaire de vide, cette machine (1) étant **caractérisée en ce qu'**elle comprend :
- des premiers moyens (18) de mise en communication commandée du capteur (15) de pression avec l'enceinte (8).

2. Machine (1) selon la revendication 1, dans laquelle le circuit (19) secondaire de vide comprend une source (20) secondaire de dépression embarquée, distincte d'une source (13) primaire de dépression du circuit (12) primaire.

3. Machine (1) selon la revendication 1 ou 2, dans laquelle le capteur (15) de pression est un capteur à chambre (24) unique, raccordée à la fois à l'enceinte (8) et au circuit (19) secondaire de vide.

4. Machine (1) selon la revendication 1 ou 2, dans laquelle le capteur (15) de pression est un capteur différentiel, dont une première chambre (26) est raccordée à l'enceinte (8) et une seconde chambre (27) au circuit (19) secondaire de vide.

5. Machine (1) selon la revendication 4, qui comprend des troisièmes moyens (29) de mise en communication des deux chambres (26, 27) du capteur (15).

6. Machine (1) selon la revendication 5, dans laquelle les troisièmes moyens (29) de mise en communication se présentent sous la forme d'une électrovanne interposée entre les deux chambres (26, 27) du capteur (15) différentiel.

7. Machine (1) selon l'une des revendications 1 à 6, dans laquelle les premiers et deuxièmes moyens (18, 23) de mise en communication se présentent sous la forme, respectivement, d'une première électrovanne interposée entre le capteur (15) et l'enceinte (8), et d'une seconde électrovanne interposée entre le capteur (15) et une source (20) secondaire de dépression du circuit (19) secondaire de vide.

8. Procédé de réétalonnage du capteur (15) de la machine (1) selon la revendication 3, suivant lequel on ferme la communication entre le capteur (15) et l'enceinte (8), on met le capteur (15) en communication avec le circuit (19) secondaire de vide, on mesure la valeur de la pression régnant dans le circuit (19) secondaire de vide, et on affecte cette valeur à une valeur de pression de référence du capteur (15).

9. Procédé de réétalonnage du capteur de la machine selon la revendication 5 ou 6, suivant lequel on ferme la communication entre le capteur (15) et l'enceinte (8), on met le capteur (15) en communication avec le circuit (19) secondaire de vide, on met les deux chambres (26, 27) du capteur (15) en communication, on mesure la valeur de la pression régnant dans le circuit (19) secondaire de vide par la seconde chambre (27), et on affecte cette valeur à une valeur de pression de référence de la seconde chambre (27).

10. Procédé de réétalonnage selon la revendication 8 ou 9, suivant lequel on évalue la réponse dynamique du capteur (15).

## Claims

1. Machine (1) for plasma treatment of containers (4), said machine (1) comprising:
- an enclosure (8) for receiving a container (4) to be treated, said enclosure (8) being connected to a primary vacuum circuit (12),
- a pressure sensor (15) connected to the enclosure (8),
- a secondary vacuum circuit (19), independent of the primary circuit (12) and connected to the pressure sensor (15), and
- second means (23) for placing the pressure sensor (15) in communication with the secondary vacuum circuit (19), said machine (1) being **characterized in that** it comprises:
- first means (18) for placing the pressure sensor (15) in controlled communication with the enclosure (8).

2. Machine (1) according to claim 1, wherein the secondary vacuum circuit (19) comprises an integrated secondary source (20) of suction, separate from a primary source (13) of suction of the primary circuit (12).

3. Machine (1) according to claim 1 or 2, wherein the pressure sensor (15) is a sensor with a single chamber (24), connected to both the enclosure (8) and the secondary vacuum circuit (19).

4. Machine (1) according to claim 1 or 2, wherein the pressure sensor (15) is a differential sensor, of which a first chamber (26) is connected to the enclosure (8) and a second chamber (27) to the secondary vacuum circuit (19).

5. Machine (1) according to claim 4, which comprises third means (29) for placing the two chambers (26, 27) of the sensor (15) in communication.

6. Machine (1) according to claim 5, wherein the third means (29) for communication are in the form of an electromagnetic valve interposed between the two chambers (26, 27) of the differential sensor (15).

7. Machine (1) according to one of claims 1 to 6, wherein the first and second means (18, 23) for communication are in the form of a first electromagnetic valve interposed between the sensor (15) and the enclosure (8), and a second electromagnetic valve interposed between the sensor (15) and a secondary source (20) of suction of the secondary vacuum circuit (19), respectively.

8. Method for recalibrating the sensor (15) of the machine (1) according to claim 3, according to which communication between the sensor (15) and the enclosure (8) is closed, the sensor is put into communication with the secondary vacuum circuit (19), the value of the pressure in the secondary vacuum circuit (19) is measured, and said value is assigned to a reference pressure value of the sensor (15).

9. Method for recalibrating the sensor of the machine according to claim 5 or 6, according to which communication between the sensor (15) and the enclosure (8) is closed, the sensor (15) is placed in communication with the secondary vacuum circuit (19), the two chambers (26, 27) of the sensor (15) are placed in communication, the value of the pressure in the secondary vacuum circuit (19) is measured by the second chamber (27), and said value is assigned to a reference pressure value of the second chamber (27).

10. Method for recalibration according to claim 8 or 9, according to which the dynamic response of the sensor (15) is evaluated.

## Patentansprüche

1. Maschine (1) zur Behandlung von Behältern (4) mit Plasma, wobei diese Maschine (1) Folgendes umfasst:
- eine Umfassung (8), die zum Aufnehmen eines zu behandelnden Behälters (4) geeignet ist, wobei diese Umfassung (8) mit einem primären Vakuumkreis (12) verbunden ist,
- einen Drucksensor (15), der mit der Umfassung (8) verbunden ist,
- einen sekundären Vakuumkreis (19), der von dem primären Kreis (12) unabhängig und mit dem Drucksensor (15) verbunden ist, und
- zweite Mittel (23) zur Herstellung einer Verbindung des Drucksensors (15) mit dem sekundären Vakuumkreis (19),
wobei diese Maschine (1) **dadurch gekennzeichnet ist, dass** sie Folgendes umfasst:
- erste Mittel (18) zur Herstellung einer Steuerverbindung des Drucksensors (15) mit der Umfassung (8).

2. Maschine (1) nach Anspruch 1, wobei der sekundäre Vakuumkreis (19) eine eingebaute sekundäre Unterdruckquelle umfasst, die sich von einer primären Unterdruckquelle (13) des primären Kreises unterscheidet.

3. Maschine (1) nach Anspruch 1 oder 2, wobei der Drucksensor (15) ein Sensor mit einer einzigen Kammer (24) ist, der gleichzeitig mit der Umfassung (8) und dem sekundären Vakuumkreis (19) verbunden ist.

4. Maschine (1) nach Anspruch 1 oder 2, wobei der Drucksensor (15) ein Differentialsensor ist, in dem eine erste Kammer (26) mit der Umfassung (8) und eine zweite Kammer (27) mit dem sekundären Vakuumkreis (19) verbunden ist.

5. Maschine (1) nach Anspruch 4, die dritte Mittel (29) zur Herstellung einer Verbindung der zwei Kammern (26, 27) des Sensors (15) umfasst.

6. Maschine (1) nach Anspruch 5, wobei die dritten Mittel (29) zur Herstellung einer Verbindung die Form eines Magnetventils aufweisen, das zwischen den zwei Kammern (26, 27) des Differentialsensors (15) angeordnet ist.

7. Maschine (1) nach einem der Ansprüche 1 bis 6, wobei die ersten und die zweiten Mittel (18, 23) zur Verbindung einer Herstellung die Form eines ersten Magnetventils, das zwischen dem Sensor (15) und der Umfassung (8) angeordnet ist, bzw. eines zweiten Magnetventils, das zwischen dem Sensor (15) und einer sekundären Unterdruckquelle (20) des sekundären Vakuumkreises (19) angeordnet ist, aufweisen.

8. Verfahren zur Neukalibrierung des Sensors (15) der Maschine (1) nach Anspruch 3, wonach die Verbindung zwischen dem Sensor (15) und der Umfassung (8) geschlossen wird, der Sensor (15) in Verbindung mit dem sekundären Vakuumkreis (19) gebracht wird, der Wert des in dem sekundären Vakuumkreis (19) herrschenden Drucks gemessen wird und dieser Wert einem Bezugsdruckwert des Sensors (15) zugeordnet wird.

9. Verfahren zur Neukalibrierung des Sensors der Maschine nach Anspruch 5 oder 6, wonach die Verbindung zwischen dem Sensor (15) und der Umfassung (8) geschlossen wird, der Sensor (15) in Verbindung mit dem sekundären Vakuumkreis (19) gebracht wird, die zwei Kammern (26, 27) des Sensors (15) in Verbindung gebracht werden, der Wert des in dem sekundären Vakuumkreis (19) herrschenden Drucks durch die zweite Kammer (27) gemessen wird und dieser Wert einem Bezugsdruckwert der zweiten Kammer (27) zugeordnet wird.

10. Verfahren zur Neukalibrierung nach Anspruch 8 oder 9, wonach die dynamische Antwort des Sensors (15) bewertet wird.
